# EUROPÄISCHE PATENTANMELDUNG

(11) **EP 1 378 939 A2**
(43) Veröffentlichungstag der Anmeldung: **07.01.2004**
(21) Anmeldenummer: 03010974.8
(22) Anmeldetag: 16.05.2003
(51) Int. Cl.: H01L 23/06, H01L 23/552

(54) **Verfahren zur Herstellung einer elektronischen Schaltung und elektronische Schaltung**

(30) Priorität: 05.07.2002 DE 10230304
(71) Anmelder: Valeo Schalter und Sensoren GmbH, 74321 Bietigheim-Bissingen (DE)
(72) Erfinder: Biehlmann, Bernd, 71638 Ludwigsburg (DE); Walz, Dirk, 72654 Neckartenzlingen (DE); Künzler, Frank, 76703 Kraichtal (DE); Papziner, Uwe, 71739 Oberriexingen (DE)
(74) Vertreter: Dreiss, Fuhlendorf, Steimle & Becker

(57) **Zusammenfassung**

Verfahren zur Herstellung einer elektronischen Schaltung (4), insbesondere einer Hochfrequenzschaltung, sowie elektronische Schaltung aufweisend eine Mehrzahl von elektronischen Baueilen (2), die auf einer Trägerplatte (1) angeordnet und mindestens teilweise mittels einer Haube (3) zum Schutz gegen äußere Einflüsse dicht verschlossen sind, wobei das Verfahren folgende Schritte aufweist:
a). Herstellen der Haube (3) mittels Spritzgießen aus einem Material, dessen thermischer Ausdehnungskoeffizient auf die abzudeckenden elektronischen Bauteile (2) abgestimmt ist; und
b). festes Verbinden der Haube (3) mit der Trägerplatte (1).

## Beschreibung

Die Erfindung betrifft ein Verfahren zur Herstellung einer elektronischen Schaltung, insbesondere einer Hochfrequenzschaltung, sowie eine elektronische Schaltung mit einer Haube bzw. Abdeckung zum Schutz gegen äußere Einflüsse.

Bei elektronischen Schaltungen, insbesondere bei Hochfrequenzschaltungen, ist es erforderlich, dass die Schaltung effektiv gegen äußere Einflüsse und insbesondere gegen Feuchtigkeit und Störungen durch elektromagnetische Felder geschützt wird. Hierzu ist es bekannt, eine haubenartige Abdeckung über die elektronische Schalteinheit, bestehend aus elektronischen Bauteilen, welche auf einer Leiterplatte angeordnet und verbunden sind, dicht zu verschließen. Diese Schutzhaube wird dabei herkömmlicherweise mit Spritzgießtechniken hergestellt und über Dichtungen mit der Leiterplatte so verbunden, dass ein Gleiten zwischen der Haube und der Leiterplatte der elektronischen Schaltung möglich ist. Dies ist erforderlich, da im Betrieb der Schaltung, insbesondere bei hochfrequenten Schaltungen, das heißt bei Frequenzen über 1 MHz, die thermische Ausdehnung der elektronischen Bauteile verschieden ist von der thermischen Ausdehnung der sie abdeckenden Haube. Eine feste, d.h. im wesentlichen bewegungsstarre Verbindung zwischen Haube und Leiterplatte würde unweigerlich zum Übertrag von mechanischen Spannungen auf die elektronischen Bauteile auf der Platine sowie zu Undichtigkeiten im Betrieb der elektronischen Schaltung führen. Das Herstellen von derartigen elektronischen Schaltungen ist teuer und aufwändig, da das Material der Dichtungsmasse kostenintensiv ist und die Anbringung der Dichtung und das Verbinden der Haube mit der Leiterplatte in einer Weise, welche ein relatives Verschieben der Haube zu der Leiterplatte erlaubt, zeitaufwändig sind.

Die vorliegende Erfindung hat demgegenüber die Aufgabe, ein Verfahren zur Herstellung einer elektronischen Schaltung sowie eine elektronische Schaltung, insbesondere eine Hochfrequenzschaltung, bereitzustellen, welche einen effektiven und dauerhaften Schutz gegen äußere Einflüsse aufweist und in ihrer Herstellung vereinfacht und kostengünstiger ist gegenüber den bisher bekannten Verfahren zur Herstellung derartiger Schaltungen.

Diese Aufgabe wird erfindungsgemäß dadurch gelöst, dass bei dem Herstellungsverfahren nach Anspruch 1 die Haube, welche die elektronischen Bauteile einer Trägerplatte mindestens teilweise dicht verschließt, aus einem Material z.B. mittels Spritzgießen hergestellt wird, dessen thermischer Ausdehnungskoeffizient auf die abzudeckenden elektronischen Bauteile abgestimmt ist. Unter Ausdehnung wird hierbei insbesondere die Ausdehnung der Trägerplatte und der Haube in eine Längsrichtung verstanden, d.h. in einer Richtung parallel zu der durch die Trägerplatte gebildeten Ebene. Hierdurch kann das Haubenmaterial spezifisch auf die jeweilige thermische Ausdehnung einer elektronischen Schaltungsgesamtheit so ausgewählt werden, dass sich eine im Wesentlichen gleiche Ausdehnung von Haube und elektronischer Schaltung im Betrieb der elektronischen Schaltung ergibt. Es ist somit nicht mehr erforderlich, die Verbindung der Haube mit der Leiterplatte der Schaltungseinheit auf gleitende bzw. bewegliche Art vorzusehen, da die Ausdehnungen von Haube und Leiterplatte bei einer Erwärmung (unabhängig davon, ob sie durch die Umgebung oder durch die elektronischen Bauteile entsteht) im Wesentlichen die gleichen sind. Es ist daher möglich, die Haube an der Leiterplatte durch Verfahren zu verbinden, welche eine feste, das heißt unbewegliche, Verbindung zwischen den Teilen bereitstellen. Durch das Herstellen einer festen Verbindung zwischen Haube und Leiterplatte der elektronischen Schaltung ist so eine hohe Dichtigkeit gegen Feuchtigkeit auch dauerhaft sicher gewährleistet.

Nach einer vorteilhaften Ausgestaltung des erfindungsgemäßen Verfahrens wird die Haube mit der Trägerplatte durch Verkleben oder Verlöten fest verbunden. Die Verbindung durch Verkleben ist einfach und schnell zu realisieren, wobei die Verbindung durch Verlöten eine besonders hohe Dichtigkeit und Dauerhaftigkeit bereitstellt.

Nach einer weiteren vorteilhaften Ausgestaltung der Erfindung wird die Haube elektrisch leitfähig mit der Trägerplatte verbunden zum Herstellen einer Abschirmung für die elektronischen Bauteile gegen störende Einflüsse aufgrund von elektromagnetischen Feldern. Dies hat den Vorteil, dass die elektrische Schaltung nicht nur dicht gegen Eindringen von Feuchtigkeit verschlossen ist, sondern dass auch hochfrequente elektronische Schaltungen, wie zum Beispiel Radar-Sensoren, Hochfrequenzverstärker oder dergleichen, vor einer Störung durch elektromagnetische, äußere Einflüsse sicher abgeschirmt sind.

Die Aufgabe der Erfindung wird auch durch eine elektronische Schaltung mit den Merkmalen des Anspruchs 5 gelöst. Die elektronischen Bauteile der Schaltung, welche auf einer Trägerplatte angeordnet sind, sind mindestens teilweise zum Schutz gegen äußere Einflüsse durch eine Haube dicht verschlossen, welche aus einem Material gebildet ist, dessen thermischer Ausdehnungskoeffizient spezifisch auf die thermische Ausdehnung der abzudeckenden elektronischen Bauteile abgestimmt ist, und wobei die Haube mit der Leiterplatte fest verbunden ist. D.h. die Verbindung ist im wesentlichen bewegungsstarr. Hierdurch ist einerseits die absolute Dichtheit gegen Feuchtigkeit gewährleistet, da die Haube fest an der Leiterplatte und nicht über etwaige nachgiebige Dichtungsmaterialien verbunden ist. Andererseits ist die thermische Ausdehnung der Haube aufgrund einer Erwärmung der elektronischen Bauteile im Betrieb der Schaltung durch die spezifische Materialwahl der Haube so auf die Ausdehnung der Bauteile abgestimmt, dass ein Beschädigen oder ein Sichlösen der festen Verbindung zwischen der Haube und der Trägerplatte, auf welcher die Bauteile angeordnet sind, vermieden wird.

Nach einer vorteilhaften Ausgestaltung der Erfindung wird die Haube an der Trägerplatte durch Klebung oder Lötung fest verbunden. Hierdurch wird nicht nur eine feste und dauerhafte Verbindung von Haube und Trägerplatte gewährleistet, sondern die Herstellung der Verbindung ist auch einfach und wenig zeitintensiv.

Nach einer weiteren vorteilhaften Ausgestaltung der Erfindung ist die Haube aus einem spezifischen Material, entsprechend dem erforderlichen thermischen Ausdehnungskoeffizient, mittels Spritzgießen hergestellt. Die Technologie des Spritzgießens ermöglicht eine sehr genaue Abstimmung bei der Wahl des Materials für die Haube, so dass die thermische Ausdehnung von Haube und Trägerplatte der elektronischen Schaltung annähernd identisch ist. Das spezifische Material kann z.B. eine Mischung aus unterschiedlichen Kunststoffen oder ein spezieller Faserwerkstoff, wie z.B. Glasfasern sein.

Nach einer weiteren vorteilhaften Ausgestaltung der Erfindung verschließt die Haube die elektronischen Bauteile, welche von ihr abgedeckt werden, feuchtigkeitsdicht. Ein Eindringen von Feuchtigkeit und damit eine Störung bzw. Beeinträchtigung der Funktionsweise der elektronischen Schaltung wird vermieden.

Nach einer weiteren vorteilhaften Ausgestaltung der Erfindung ist die Haube elektronisch leitend mit der Trägerplatte verbunden und geeignet zur Abschirmung der elektronischen Bauteile gegen Störungen durch elektromagnetische Felder. Hierdurch werden insbesondere hochfrequente elektronische Schaltungen, wie zum Beispiel Hochfrequenzverstärker, Radar-Sensoren oder dergleichen, durch äußere elektromagnetische Strahlungen nicht in ihrer Funktionsweise beeinträchtigt.

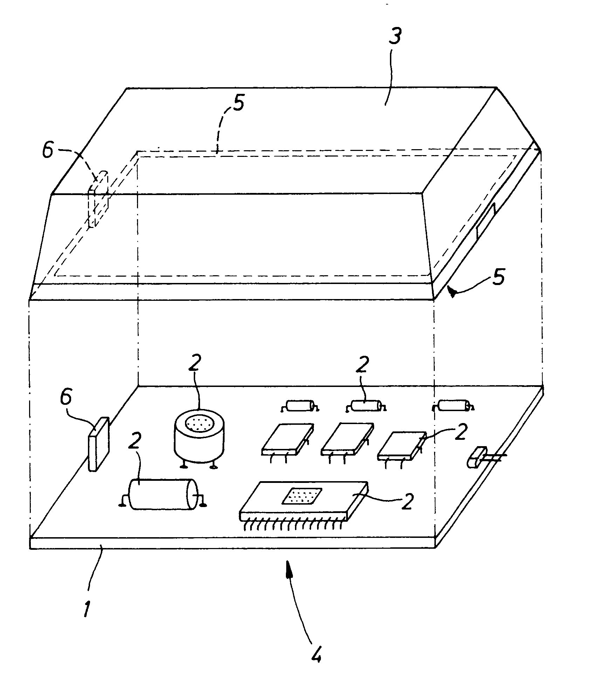

Weitere Merkmale, Vorteile und vorteilhafte Ausgestaltungen der Erfindung sind der nachfolgenden Beschreibung zu entnehmen, in welcher die Erfindung anhand des in der Zeichnung dargestellten Ausführungsbeispiels im Detail beschrieben und erläutert ist.

In der Figur ist eine elektronische Schaltungseinheit 4 gemäß der Erfindung schematisch in perspektivischer Ansicht dargestellt vor einem Verbinden der Haube 3 mit der Trägerplatte 1. Die Trägerplatte ist hier eine Leiterplatte 1 weist eine Mehrzahl von elektronischen Bauteilen 2 auf, welche auf der Leiterplatte 1 befestigt und elektronisch miteinander verbunden sind. Die Leiterplatte 1 ist beispielsweise eine herkömmliche Platine einer elektronischen Schaltung. Die Haube 3 ist vorgesehen zum Verbinden mit der Leiterplatte 1, so dass ein Schutz der elektronischen Bauteile 2 gegen äußere Einflüsse, wie zum Beispiel Feuchtigkeit, Schmutz oder elektromagnetische Strahlung, bereitgestellt wird. Die elektronischen Bauteile können u.a. spröde, keramische Bauteile sein (Transistoren oder Dioden aus Si/Glas, GaAs-Bauteile, Kondensatoren oder dgl.), die anfällig gegenüber Spannungen sind. Die Haube 3 ist aus einem Material z.B. durch Spritzgießen hergestellt, welches spezifisch auf die thermische Ausdehnung der elektronischen Bauteile 2 insgesamt abgestimmt ist. Selbstverständlich kann die Haube 3 auch durch andere dem Fachmann bekannte Formgebungsverfahren hergestellt sein, abhängig vom jeweiligen Material. Das spezifische Material der Haube 3 ist zum Beispiel ein Mischmaterial, bestehend aus einer Mischung verschiedener Kunststoffmaterialien, welche aufgrund ihrer material-physikalischen Eigenschaften in ihrer Mischung einen gewünschten thermischen Ausdehnungskoeffizient aufweisen. Hierdurch wird eine aufwändige Gleitverbindung zwischen Platine und Haube 3 vermieden, wie sie bisher unter hohem Zeitaufwand durch Dichtraupen hergestellt wurde, die Dichtigkeit wird erhöht und eine Aufbau von Spannungen wird effektiv vermieden.

Die Haube 3 weist innen an ihrer unteren Kante eine Fase 5 auf, die auf die äußere Abmessung der Leiterplatte 1 abgestimmt ist, so dass die Leiterplatte 1 sich bündig mit dem unteren Rand der Haube 3 in diese letztere einsetzen lässt.

Die Fase 5 dient hierbei einem besseren Halt und einer besseren Verklebung bzw. Verlötung der Haube 3 mit der Leiterplatte 1. Weiterhin weisen die Leiterplatte 1 einerseits und die Haube 3 andererseits jeweils elektronische Kontakte 6 auf, zum elektronisch leitenden Verbinden der Haube 3 mit der Leiterplatte 1 zum Erzeugen einer Abschirmung der Haube 3 gegen störende Einflüsse aufgrund einer äußeren, elektromagnetischen Strahlung. Bei dem in der Figur dargestellten Ausführungsbeispiel deckt die Haube 3 die gesamte Leiterplatte 1 und damit die Gesamtheit der elektronischen Bauteile 2 ab. Es ist jedoch auch möglich, dass nur ein Teil der elektronischen Bauteile 2, beispielsweise elektronische Bauteile, die einen hochfrequenten Bereich der elektronischen Schaltung bilden, von einer Haube abgedeckt werden, um lediglich diese gegen elektromagnetische Störeinflüsse, wie Feuchtigkeit, Wasser, Staub oder auch elektromagnetische Strahlung, abzuschirmen. Es ist auch möglich, dass die Haube 3 mit der Leiterplatte 1 nicht elektronisch leitend verbunden ist, so dass die Haube 3 lediglich zur Abdichtung gegen Feuchtigkeit und Schmutz oder dergleichen dient.

Sämtliche in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Verfahren zur Herstellung einer elektronischen Schaltung (4), insbesondere einer Hochfrequenzschaltung, aufweisend eine Einzahl oder Mehrzahl von elektronischen Baueilen (2), die auf einer Trägerplatte (1) angeordnet und mindestens teilweise mittels einer Haube (3) zum Schutz gegen äußere Einflüsse dicht verschlossen sind, **gekennzeichnet durch**:
a). Herstellen der Haube (3) mittels Spritzgießen aus einem Material, dessen thermischer Ausdehnungskoeffizient auf die abzudeckenden elektronischen Bauteile (2) abgestimmt ist; und
b). festes Verbinden der Haube (3) mit der Trägerplatte (1).

2. Verfahren nach Anspruch 1, **gekennzeichnet durch** Verkleben der Haube (3) mit der Trägerplatte (1).

3. Verfahren nach Anspruch 1 oder 2, **gekennzeichnet durch** Verlöten der Haube (3) mit der Trägerplatte (1).

4. Verfahren nach einem der vorherigen Ansprüche, **gekennzeichnet durch** elektrisch leitfähiges Verbinden der Haube (3) mit der Trägerplatte (1) zum Abschirmen der elektronischen Bauteile (2) gegen äußere, elektromagnetisch störende Einflüsse.

5. Elektronische Schaltung (4) mit einer Mehrzahl von elektronischen Bauteilen (2), welche auf einer Trägerplatte (1) angeordnet sind, und welche mit einer Haube (3) mindestens teilweise zum Schutz gegen äußere Einflüsse dicht verschlossen sind, **dadurch gekennzeichnet, dass** die Haube (3) aus einem Material gebildet ist, dessen thermischer Ausdehnungskoeffizient auf die thermische Ausdehnung der abzudeckenden elektronischen Bauteile (2) abgestimmt ist und dass die Haube (3) mit der Trägerplatte (1) fest verbunden ist.

6. Elektronische Schaltung (4) nach Anspruch 5, **dadurch gekennzeichnet, dass** die Haube (3) mit der Trägerplatte (1) durch Klebung oder Lötung fest verbunden ist.

7. Elektronische Schaltung (4) nach Anspruch 5 oder 6, **dadurch gekennzeichnet, dass** die Haube (3) aus einem spezifischen Material entsprechend dem erforderlichen thermischen Ausdehnungskoeffizient der Gesamtheit der elektronischen Bauteile (2) mittels Spritzgießen hergestellt ist.

8. Elektronische Schaltung (4) nach einem der vorherigen Ansprüche, **dadurch gekennzeichnet, dass** die Haube (3) feuchtigkeitsdicht die elektronischen Bauteile (2) verschließt.

9. Elektronische Schaltung (4) nach einem der vorherigen Ansprüche, **dadurch gekennzeichnet, dass** die Haube (3) elektrisch leitend mit der Trägerplatte (1) verbunden ist und geeignet ist zur Abschirmung der Bauteile (2) gegen Störungen durch elektromagnetische Felder.

10. Elektronische Schaltung (4) nach Anspruch 9, **dadurch gekennzeichnet, dass** sie eine hochfrequente Schaltung ist.
